## Europäisches Patentamt
## European Patent Office
## Office européen des brevets

(11) Publication number: **0 240 934**
**A2**

# EUROPEAN PATENT APPLICATION

(21) Application number: **87104866.6**

(22) Date of filing: **02.04.87**

(51) Int. Cl.³: **H 03 L 7/18**

(30) Priority: **08.04.86 PL 258835**

(43) Date of publication of application:
**14.10.87 Bulletin 87/42**

(84) Designated Contracting States:
**DE FR NL**

(71) Applicant: **Przemyslowy Instytut Telekomunikacji**
**ul. Poligonowa 30**
**PL 00-991 Warszawa(PL)**

(72) Inventor: **Subotic, Zivko**
**ul. Walewska 3 m. 27**
**Warzawa(PL)**

(74) Representative: **Ebbinghaus, Dieter et al,**
**Patentanwälte v. Füner, Ebbinghaus, Finck Mariahilfplatz**
**2 & 3**
**D-8000 München 90(DE)**

(54) **Digital frequency synthesizer.**

(57) The subject of the invention is a digital frequency synthesizer having particular application in telecommunications.

A digital frequency synthesizer as per this present invention is remarkable in that it comprises a second digital frequency divider (4) of constant division ratio connected to a control system (6) which, in turn, is connected to a synthesized frequency output generator (8), a phase detector (3) and the output of an adjustable-width gate forming system (5). The input of the adjustable-width gate forming system (5) is connected to the second input of the phase detector (3). The second digital frequency divider (4) is connected between the output of the synthesized frequency output generator (8) and the other output of the control system (6) whose output, in turn, is connected to the other input of the phase detector (3).

Fig. 1

Croydon Printing Company Ltd

v. FUNER     EBBINGHAUS     FINCK

PATENTANWÄLTE     EUROPEAN PATENT ATTORNEYS

MARIAHILFPLATZ 2 & 3, MÜNCHEN 90
POSTADRESSE: POSTFACH 95 01 60, D-8000 MÜNCHEN 95

**0240934**

Przemysłowy Instytut          EPAB-34786.4     DE/Ks
Telekomunikacji               April 2, 1987


## Digital Frequency Synthesizer

The subject of the invention is a digital frequency synthesizer having particular application in telecommunications.


The digital frequency synthesizer known until now from,
for example, Polish Patent Specification No. 100,484 consists of a reference oscillator connected via a digital
divider of constant frequency division ratio with a phase
detector whose output is connected to a synthesizer frequency generator. The second phase detector input is connected by means of a feedback system comprising a synthesized frequency pulse formulation system and a control
block of counted pulse sequence.


The control block of counted pulse sequence consists of an
adjustable digital divider, a monostable multi-vibrator
system, a pulse distribution system and a control system
connected to one antoher in series to form a closed circuit. Also, the output of the pulse forming system has
been connected to the other input of the control system.


On the other hand, the output of the pulse forming and
shifting system is connected to the other input of the
pulse distribution system. The outputs, both of the pulse
forming system and the pulse forming and shifting system,
are connected to each other and to the output of the synthesized frequency pulse forming system. The output of
the adjustable digital divider is connected to the
other phase detector output in addition to its being connected to the input of the monostable mulit-vibrator system. The digital frequency synthesizer known from the said patent differs in its second version from the above-mentioned synthesizer in that only the second input of the pulse forming system with its input connected to the output of the synthesized frequency pulse forming system has connected thereto the output of the pulse forming system with its input connected to the output of the synthesized frequency pulse forming system.

On the other hand, the output of the adjustable digital divider and the input of the monostable multivibrator system are connected to the other input of the phase detector.

The disadvantageous feature of the known digital frequency synthesizer is the application of an adjustable digital divider with its limitations in pulse propagation in the control block of counted pulse sequence, which does not allow the upper value of synthesized frequencies to be increased.

The purpose of the invention is to develop a digital frequency synthesizer with the upper synthesized frequencies higher than those of the known synthesizers with the possibility of programming the synthesis step and continuous resetting ensured at the present step. This has been achieved by using simple systems controlling pulse flow and counting.

The digital frequency synthesizer as per this present invention is remarkable in that it comprises another digital frequency divider with constant division ratio, connected to the control system which, in its turn, is connected to the synthesized frequency output generator, the phase detector and the output of the adjustable-width gate forming system. The input of the adjustable-width gate forming system is connected to the other input of the phase detector. The other digital frequency divider with constant division ratio is connected between the output of the synthesized frequency output generator and the other input of the control system whose output is, in its turn, connected to the other input of the phase detector.

The second version of the digital frequency divider with constant division ratio is connected between the output of the synthesized frequency output generator and the other input of the control system, whereas the output of the control system is connected to the other input of the other digital frequency divider with constant division ratio, whose other output is connected to the other input of the phase detector.

The third version of the other digital frequency divider with constant division ratio is connected between the output of the control system and the other input of the phase detector. The input of the control system is connected to the output of the synthesized frequency output generator.

The advantageous feature of the digital frequency synthesizer as per the present invention is the generation of limiting frequencies higher than those of the synthesizers known until now with simple construction of the system retained and continuous resetting employed.

Besides, this synthesizer ensures high reliability and stability of operation.

The digital frequency synthesizer as per this present invention will be explained in more detail with reference to the accompanying drawings, in which:

Fig. 1   shows the block diagram of the first version,

Fig. 2   shows the block diagram of the second version, and

Fig. 3   shows the block diagram of the third version.

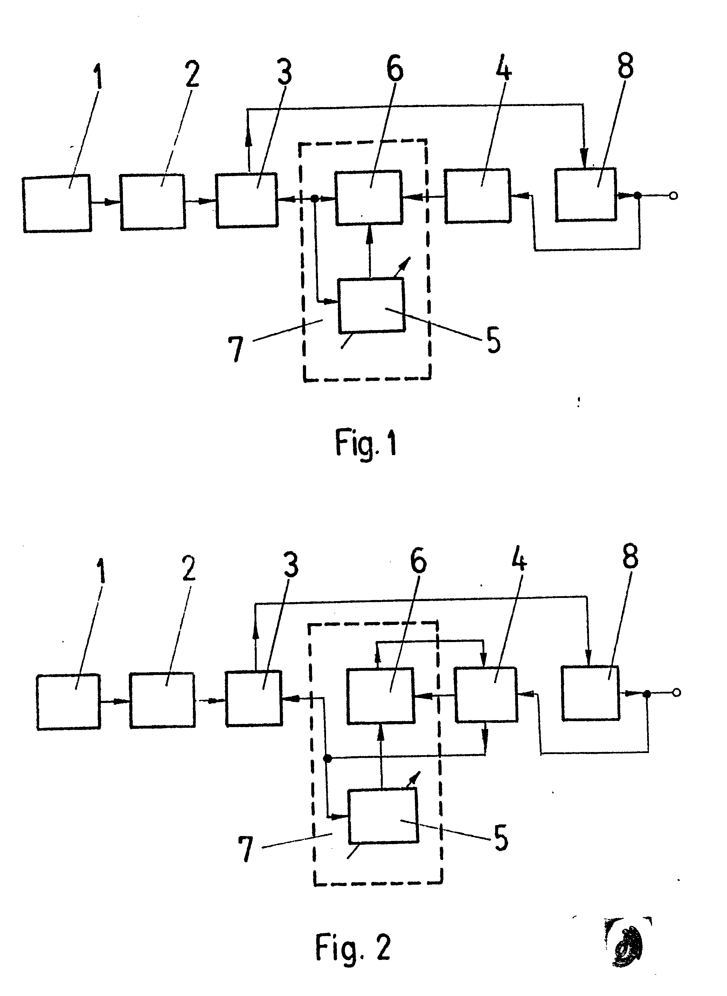

The first version (Fig. 1) of the digital frequency synthesizer as per this present invention consists of a reference oscillator 1 in the form of a quartz generator whose output is connected via a digital frequency divider 2 built up from integrated systems, having a constant division ratio, ensuring the present synthesized step and connected to a first input of a phase detector 3 in the form of a system integrated with a proportionally integrating filter.

The output of the proportionally integrating filter of phase detector 3 is connected to the input of a backwardly polarized capacity diode of the resonance circuit of synthesized frequency output generator 8 reset electronically.

The output of synthesized frequency output generator 8 is connected via another digital frequency divider 4 of constant division ratio built up from integrated systems, and ensuring the minimum synthesized frequency and being connected the one input of control system 6 which is a double product gate in the form of an integrated system. The other input of the control system 6 is connected to the output of the adjustable-width gate forming system 5 which is a monostable multivibrator in the form of an integrated system with a variable one-or multi-rotation potentiometer in the RC time constant circuit of that multivibrator.

The output of the control system 6 is connected in parallel to the other input of phase detector 3 and that of adjustable-width gate forming system 5. Control system 6 and adjustable-width gate forming system 5 which is a monostable multivibrator form a gating system 7.

The second version (Fig. 2) of the digital frequency synthesizer differs from its first version in that the second digital frequency divider 4 of constant division ratio has two inputs and two outputs. One of its inputs is connected to the output of synthesized frequency output generator 8, the other being connected to the output of the control system 6. Also, one output of the second digital frequency divider 4 of constant division ratio 4 is connected to one input of the control system 6, the other being connected in parallel to the other input of phase detector 3 and the input of adjustable-width gate forming system 5.

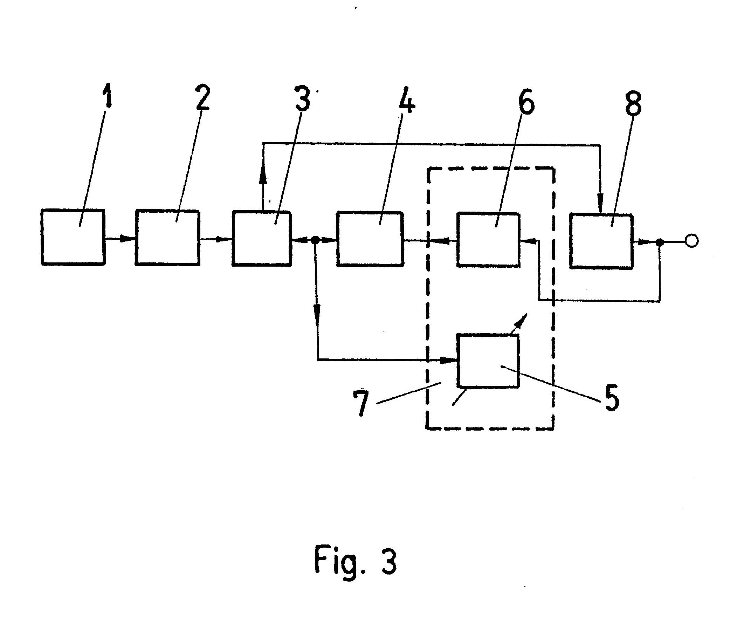

The third version (Fig. 3) of the digital frequency synthesizer differs from its first version in that the output of synthesized frequency output generator 8 is connected to the input of control system 6 whose output is connected to the input of the second digital frequency divider 4 of constant division ratio. The output of digital frequency divider 4 is connected in parallel to the other input of phase detector 3 and the input of adjustable-width gate forming system 5.

The operation of the digital frequency synthesizer as per this present invention is now described below.

After the passage of No, where No is the constant division ratio of the second digital frequency divider 4 of constant division ratio, of the pulses formed from the signal of the electronically reset synthesized frequency output generator 8 through the control system 6 and the second frequency divider 4 of constant division ratio a cancelling pulse is formed which starts a multivibrator of the adjustable-width gate forming system 5.

The pulse coming from the above-mentioned multivibrator, having the duration $\tau$ and adjusted by the varying potentiometer of adjustable-width gate forming system 5 blocks the double product gate of the control system 6. At the same time, the digital frequency divider 4 does not receive the pulses from the electronically reset synthesized frequency output generator 8. On completion of the pulse with duration $\tau$ in the adjustable-width gate forming system 5 the double product gate of the control system 6 is deblocked and digital frequency divider 4 starts to count the pulses.

After counting No pulses, the divider becomes saturated, which causes a cancelling pulse to be formed the cycle whereof is repeated. It thus means that the duration $\tau$ is added during every counting cycle to the period $T_n$ of the counting No pulses in the second digital frequency divider 4, which prolongs the total time between two cancelling pulses also transmitted to one of the inputs of phase detector 3 with a proportionally integrating filter.

The above will cause the frequency to increase in the electronically reset synthesized frequency output generator 8.

Synchronism will occur when time interval $T + \tau = To$, where To is the repetition period of a sequence of the pulses transmitted from the output of digital divider 2 to the input of the phase detector 3.

The synthesized frequency will then reach the following value

$$f = \frac{1}{T_0} \times \frac{N_0}{1 + T_0}$$

If duration $\tau$ and $T + \tau < T_0$ are shortened due to another setting of the value of the variable potentiometer in the adjustable-width gate forming system 5, the frequency of the synthesizer will be lowered. The times of building up the adjustable-width gate forming system and the double product gate of control system 6 in the multivibrator are not critical values.

If these times are longer than the duration of the edges of the pulses transmitted to the first input, they add to duration $\tau$ and cause a constant frequency shift of the electronically reset synthesized frequency output generator 8.

Depending on the method of connecting the second digital frequency divider of constant division ratio with adjustable-width gate forming system 4, synthesis step $\Delta F$ is changed. For the design shown in Fig. 1, it is

$$\Delta F = \frac{N_0}{T_0}$$

For the design shown in Fig. 2, it is

$$\Delta F = \frac{N}{T_0}$$

where N serves a a prescaler.
For the design shown in Fig. 3, it is

$$\Delta F = \frac{1}{T_0}$$

## Claims

1. A digital frequency synthesizer consisting of a frequency reference oscillator (1) connected via a digital frequency divider (2) of constant division ratio to the input of a phase detector (3) whose output is connected to the input of a synthesized frequency output generator (8), characterized in that it comprises a second digital frequency divider (4) of constant division ratio connected to control system (6) which, in turn, is connected to the synthesized frequency output generator (8), the phase detector (3) and the an adjustable-width gate forming system (5) whose output is connected to the other input of phase detector (3).

2. A digital frequency synthesizer as per claim 1, characterized in that the second digital frequency divider (4) is connected between the output of the synthesized frequency output generator (8) and the other input of control unit (6) whose output is, in turn, connected to the other input of the phase detector (3).

3. A digital frequency synthesizer as per claim 1, characterized in that the second digital freqeuncy divider (4) is connected between the output of the synthesized frequency output generator (8) and the other input of the control system (6), whereas the output of the control system (6) is connected to the other input of the second digital frequency divider (4) whose other output is connected to the other input of the phase detector (3).

4. A digital frequency synthesizer as per claim 1, characterized in that the second digital frequency divider (4) is connected between the other input of phase detector (3) and the output of control system (6) whose input is connected to the output of the synthesized frequency output generator (8).

Fig. 1

Fig. 2

EPAB-34786.4

0240934

Fig. 3